# DEMANDE DE BREVET EUROPEEN

(11) **EP 1 447 671 A1**
(43) Date de publication de la demande: **18.08.2004**
(21) Numéro de dépôt: 04366002.6
(22) Date de dépôt: 30.01.2004
(51) Int. Cl.: G01R 19/25

(54) **Appareil de surveillance permanente d'un réseau électrique**

(30) Priorité: 13.02.2003 FR 0301713
(71) Demandeur: Arnould, Roger, 57100 Manom (FR); Boisard, Frédéric, 49000 Angers (FR); Cisamolo, Robert, 57250 Moyeuvre-Grande (FR); Daufin, Marie-Claire, 92220 Bagneux (FR); Pean, Isabelle, 49080 Bouchemaine (FR)
(72) Inventeur: Boisard, Frédéric, c/o Cabinet Ballot, 57070 Metz (FR); Pean, Isabelle, c/o Cabinet Ballot, 57070 Metz (FR)
(74) Mandataire: Bentz, Jean-Paul

(57) **Abrégé**

L'invention concerne un appareil de surveillance d'un réseau électrique, notamment un réseau domestique, enfichable sur un socle (110) de prise électrique comprenant une borne de phase, une borne de terre et une borne de neutre. L'appareil comprend une pluralité d'organes de détection (120, 130, 140) pour détecter le dépassement de valeurs limites de paramètres électriques du réseau et un dispositif de signalisation (200) pour signaler un défaut lorsqu'une valeur prédéfinie d'un paramètre est dépassée.

Selon l'invention, les paramètres électriques comprennent notamment une tension de phase, une tension de terre et une résistance de terre.

## Description

L'invention concerne un appareil de surveillance d'un réseau de distribution électrique, notamment un réseau domestique. L'invention concerne plus particulièrement un appareil de surveillance enfichable dans un socle de prise électrique à trois bornes, une borne de phase, une borne de terre et une borne de neutre et comprenant des organes pour détecter le dépassement de valeurs limites de paramètres électriques du réseau et un dispositif de signalisation d'un défaut.

De tels appareils sont déjà connus. Par exemple, le document D1 (WO 96/39634) présente un tel appareil, apte à détecter une erreur de câblage (permutation des différents câbles) ou une connexion interrompue ou en mauvais état dans le socle d'une prise, et à détecter une valeur limite de résistance de phase et de terre. Un tel appareil est notamment intéressant pour des utilisations ponctuelles ; il permet par exemple à un installateur de vérifier le câblage d'un socle de prise ou plus généralement du réseau électrique.

Un appareil tel que décrit dans D1 présente cependant de nombreux inconvénients.

Un tel appareil ne permet pas la surveillance de tous les paramètres électriques essentiels du réseau (inconvénient principal).

Par ailleurs, un tel appareil ne permet pas la surveillance continue de certains paramètres électriques du réseau, d'alerter efficacement un utilisateur lorsqu'un défaut apparaît ou de tester le bon fonctionnement dans le temps de certains équipements de protection présents sur le réseau (inconvénients secondaires).

L'invention pallie l'inconvénient principal d'un appareil selon D1 en proposant un appareil de surveillance enfichable dans un socle de prise électrique à trois bornes, appareil comprenant des organes pour détecter le dépassement de valeurs limites de paramètres électriques du réseau et un dispositif de signalisation d'un défaut, et caractérisé par le fait que les paramètres électriques surveillés sont notamment la tension de phase, la tension de terre et la résistance de terre du réseau électrique.

Un appareil selon l'invention permet ainsi de surveiller l'ensemble des paramètres du réseau desquels une variation excessive serait susceptible de mettre en danger une personne située au voisinage du réseau ou d'endommager un appareil électrique relié au réseau, et d'alerter si l'un ou l'autre de ces paramètres varie de manière excessive. La surveillance peut par ailleurs être continue si l'appareil est laissé dans un socle de prise.

L'appareil selon l'invention est enfichable dans tout socle de prise à trois bornes (phase, terre, neutre), il est portable, de petite taille et peut être déplacé aisément. L'appareil selon l'invention peut être utilisé ponctuellement, par exemple pour vérifier un réseau électrique en cours d'installation ou de rénovation. L'appareil selon l'invention peut être surtout installé à demeure sur un socle de prise particulier, par exemple en aval d'un compteur électrique associé au réseau électrique, pour assurer une surveillance continue de l'ensemble du réseau.

Selon un mode de mise en oeuvre de l'invention, l'appareil de surveillance comprend un organe de détection de la tension de phase, pour mesurer la tension de phase entre la borne de phase et la borne de neutre et produire un 1^{er} signal de défaut si la tension de phase devient supérieure à une tension maximale de phase, ou un 2^{ème} signal de défaut si la tension de phase devient inférieure à une tension minimale de phase.

L'appareil de surveillance comprend également un organe de détection de la tension de terre, pour mesurer la tension de terre entre la borne de terre et la borne de neutre et produire un 3^{ème} signal de défaut si la tension de terre devient supérieure à une tension maximale de terre.

La tension minimale de phase, la tension maximale de phase et la tension maximale de terre sont de préférence celles fixées par les normes nationales ou internationales.

L'appareil de surveillance comprend enfin un organe de détection de la résistance de terre qui produit un 4^{ème} signal de défaut si la résistance de terre devient supérieure à une résistance maximale de terre.

La résistance maximale de terre est fixée de préférence en fonction des normes appropriées et du calibre d'un disjoncteur différentiel associé au réseau sous surveillance. Le calibre peut être fixé par exemple par un utilisateur à l'aide d'un bouton de sélection. L'appareil selon l'invention est ainsi adaptable simplement quelles que soient les caractéristiques électriques du réseau (dont dépend directement le calibre du disjoncteur différentiel) et quelles que soient les normes en vigueur dans le lieu où l'appareil est utilisé.

Les moyens de détection peuvent également comprendre un moyen de mémorisation pour mémoriser un ou plusieurs des signaux de défaut, pour conserver une trace de l'apparition, même ponctuelle, de l'un ou l'autre de ces défauts. L'invention pallie ainsi l'un des défauts secondaires des appareils de surveillance connus. Cette caractéristique de l'invention présente de nombreux avantages. Par exemple, si un défaut de résistance de terre est détecté ponctuellement mais ne perdure pas (défaut intermittent), conserver une trace de ce défaut permet d'alerter et de rappeler à l'utilisateur, par exemple à des intervalles réguliers, qu'un tel défaut souvent intermittent, souvent ignoré, est particulièrement dangereux pour les personnes à proximité du réseau et les équipements qui lui sont connectés et qu'il est nécessaire de faire vérifier son installation électrique et notamment sa mise à la terre. Egalement, la mémorisation d'un défaut de surtension de la tension de phase à un moment donné permet d'expliquer la destruction d'un équipement électrique connecté en aval sur le réseau.

L'organe de détection de la résistance de terre peut être activé à intervalles réguliers, par exemple toutes les heures, tous les jours, etc. Ceci permet de pallier un autre inconvénient secondaire des appareils de surveillance connus. L'organe de détection de la résistance de terre peut aussi être activé une première fois quelques secondes après l'enfichage du dispositif de surveillance dans un socle de prise. L'utilisateur sait ainsi immédiatement si il existe un défaut de résistance de terre au moment de la mise en place de l'appareil.

Selon un autre aspect de l'invention, l'appareil de surveillance peut également comprendre un circuit de test, pour produire, entre la borne de phase et la borne de terre une impulsion de courant calibrée en fonction du calibre de l'appareil de surveillance, calibre qui est de préférence choisi en fonction du calibre d'un disjoncteur différentiel placé sur le réseau à surveiller. Le circuit de test est par exemple activé par l'utilisateur à l'aide d'un bouton poussoir. L'impulsion produite est suffisante pour faire réagir le disjoncteur. L'appareil de surveillance de l'invention pallie ainsi un autre inconvénient des appareils connus en permettant de vérifier l'état de fonctionnement du disjoncteur différentiel sur le réseau.

Selon un autre aspect de l'invention, le dispositif de signalisation comprend un moyen de signalisation pour indiquer un ou plusieurs défauts s'il reçoit un ou plusieurs signaux de défaut de la pluralité d'organes de détection, ou pour indiquer une absence de défaut sur le réseau sinon. Le dispositif de signalisation peut ainsi permettre à un utilisateur de savoir si le réseau comporte un défaut à un instant donné ou si un défaut a eu lieu à un instant donné, quel type de défaut, si les conséquences du défaut sont potentiellement importantes, si une intervention est nécessaire, etc.

Selon une variante, le dispositif de signalisation comprend un moyen de signalisation visuel comprenant un ou plusieurs dispositifs de signalisation lumineuse (par exemple des diodes électroluminescentes) qui sont éteints ou allumés en fonction de l'état actif ou inactif du ou des signaux de défaut. De préférence, un ensemble de dispositifs de signalisation lumineuse (par exemple de différentes couleurs et en nombre suffisant) est choisi de manière appropriée pour permettre la signalisation, en fonction de leur gravité, de l'ensemble des défauts susceptibles d'apparaître.

Selon une autre variante, le dispositif de signalisation comprend un moyen de signalisation sonore comprenant un ou plusieurs organes délivrant un son tels que des buzzers, activés si un ou des signaux de défaut sont actifs. Le ou les buzzers sont activés une seule fois lorsque un ou des signaux de défauts deviennent actifs, ou bien à des intervalles réguliers, par exemple si un ou des défauts perdurent (c'est-à-dire si un ou des signaux de défauts restent actifs) ou si un ou des défauts a ou ont été mémorisés. Dans un mode de réalisation particulier, seuls les défauts les plus importants en terme de sécurité sont signalés par voie sonore.

Selon un autre aspect de l'invention, la pluralité d'organes de détection est intégrée dans un même boîtier de l'appareil de surveillance. Le dispositif de signalisation est quant à lui, soit intégré également dans le même boîtier, soit déporté par rapport au boîtier de l'appareil de surveillance. Dans ce dernier cas, la pluralité d'organes de détection et le dispositif de signalisation sont reliés par une liaison filaire dédiée, une liaison hertzienne, une liaison infra-rouge, une liaison par courants porteurs, une liaison galvanique ou tout autre liaison permettant un échange d'informations à distance.

L'appareil de détection de l'invention peut être avantageusement complété par un circuit d'inversion, par exemple de type interrupteur à deux entrées et une sortie, qui permet d'inverser les points de connexion de l'appareil de surveillance aux bornes de phase et de neutre du socle de prise dans lequel il est installé. Ceci permet d'utiliser l'appareil y compris dans le cas où les fils de phase et de neutre auraient été connectés en sens inverse au niveau des bornes de phase et de neutre du socle de prise.

En résumé, dans sa version la plus élaborée, un appareil de surveillance selon l'invention est un appareil portable, enfichable directement ou par l'intermédiaire d'un adaptateur sur n'importe quel socle de prise de courant d'un réseau électrique domestique, en aval d'un compteur abonné. L'appareil est destiné à surveiller en permanence, au moyen de mesures appropriées, les différents paramètres du dit réseau électrique surtout liés à la sécurité des personnes et des biens : les variations de tension sur chaque pôle du socle de prise de courant, les variations de la valeur de la résistance de terre sur la broche correspondante ainsi que la déconnexion éventuelle de la dite terre. L'appareil est propre à signaler, par des moyens visuels et / ou sonores incorporés ou non à l'appareil, tout dépassement de ces paramètres mesurés en permanence ou de manière récurrente en comparaison avec des valeurs normalisées. L'appareil est également propre à vérifier, par un moyen accessible activé volontairement sur l'appareil, l'efficacité de fonctionnement du dispositif différentiel à résiduel de courant assurant la coupure du réseau électrique en cas de défaut, situé en amont du socle de prise de courant.

L'invention sera mieux comprise et d'autres caractéristiques et avantages apparaîtront à la lecture de la description qui va suivre, d'exemples de mise en oeuvre d'un appareil de surveillance selon l'invention. La description est à lire en relation aux dessins annexés dans lesquels :
- la figure 1 est un schéma fonctionnel d'un mode de réalisation d'un appareil selon l'invention, et
- la figure 2 est un schéma d'un autre mode de réalisation d'un appareil selon l'invention.

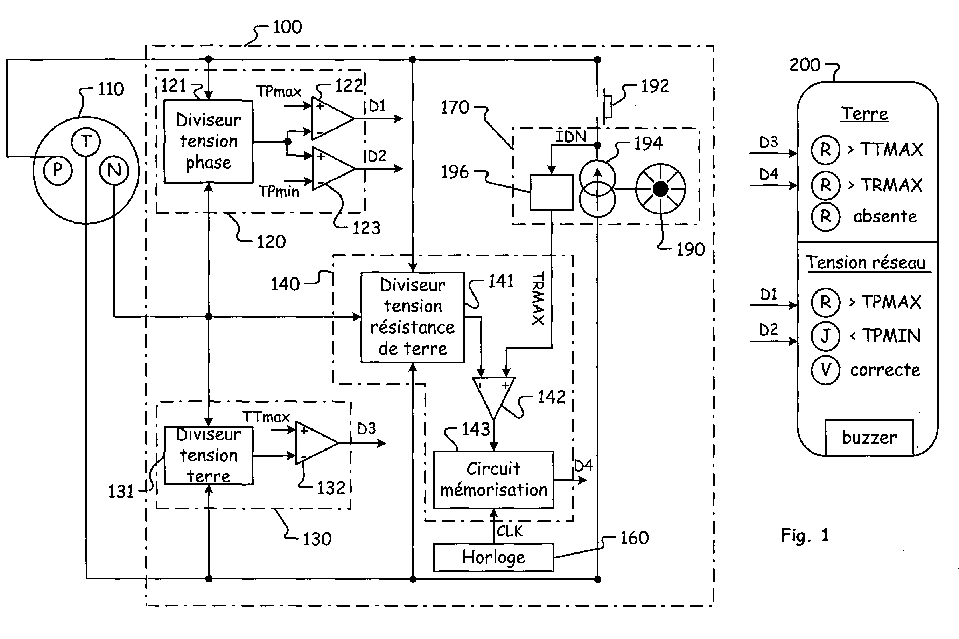

Un appareil selon l'invention tel que celui de la figure 1 comprend un dispositif de détection 100 et un dispositif de signalisation de défauts 200.

Le dispositif 100 de détection comprend un organe de détection de la tension de phase 120, un organe de détection de la tension de terre 130, un organe de détection de la résistance de terre 140, un circuit d'horloge 160 et un circuit de calibrage 170. Tous ces éléments sont intégrés dans un même boîtier enfichable dans un socle 110 de prise électrique comprenant une borne de phase, une borne de terre et une borne de neutre. L'appareil peut être utilisé ponctuellement pour tester un socle de prise ou le réseau ; il peut également être laissé à demeure dans un socle pour assurer une surveillance continue du réseau.

L'organe 120 de détection de la tension de phase comprend un pont diviseur 121 de tension et un comparateur à deux seuils de détection et à fenêtre. Le pont diviseur a deux entrées connectées respectivement à la borne de phase et à la borne de neutre, et une sortie sur laquelle est produite une image de la tension entre la phase et le neutre du socle 110. Le pont diviseur 121 est réalisé selon un schéma connu à base de résistances ou de condensateurs. Le comparateur à deux seuils comprend dans l'exemple de la figure 1 deux comparateurs 122, 123 simples à un seuil de détection. L'entrée négative du comparateur 122 et l'entrée positive du comparateur 123 sont connectées ensemble à la sortie du pont diviseur de tension 121. Le comparateur reçoit également une tension de référence TPmax sur son entrée positive et il produit un 1^{er} signal D1 de défaut si la tension en sortie du pont 121 est supérieure à TPmax, c'est à dire si la tension entre les bornes de phase et de neutre sur le socle 110 est supérieure à la valeur maximale admissible TPMAX. Le comparateur 123 reçoit quant à lui une tension de référence TPmin sur son entrée négative et il produit un 2^{ème} signal de défaut D2 si la tension entre les bornes de phase et de neutre devient inférieure à une valeur minimale TPMIN admissible. Dans un exemple, la valeur TPMAX est égale à 245 V et la valeur TPMIN est égale à 205 V, valeurs définies par la norme NFC 15 100 en vigueur en France.

L'organe 130 de détection de la tension de terre comprend dans l'exemple de la figure 1 un pont diviseur 131 et un comparateur 132. Le pont diviseur a deux entrées connectées respectivement à la borne de terre et à la borne de neutre du socle 110 et une sortie sur laquelle est produite une tension image de la tension entre la terre et le neutre. Le comparateur 132 comprend une entrée positive sur laquelle est appliquée une tension de référence TTmax et une entrée négative connectée à la sortie du pont 131. Le comparateur 132 produit un signal de défaut D3 si la tension entre la borne de terre et la borne de neutre du socle 110 est supérieure à une valeur maximale admissible TTMAX. Dans un exemple, TTMAX est choisie égale à 50 V, valeur définie par la norme NFC 15 100.

L'organe 140 de détection de la résistance de terre comprend dans l'exemple de la figure 1 un pont diviseur de tension 141, un comparateur 142 à un seuil de détection et un circuit 143 de mémorisation. Le pont diviseur 141 comprend trois entrées connectées chacune à une borne du socle 110, et une sortie sur laquelle est produite une tension proportionnelle à la résistance de terre. Le comparateur 142 a une entrée positive sur laquelle est appliquée une tension de référence TRmax proportionnelle à la résistance de terre maximale admissible et une borne négative connectée à la sortie du pont 141. Le comparateur 142 produit un signal de défaut si la résistance de terre est supérieure à une valeur maximale admissible. Le circuit 143 de mémorisation comprend une entrée connectée à la sortie du comparateur 142, une entrée sur laquelle est appliqué un signal d'horloge CLK et une sortie sur laquelle est produit le signal D4. Le circuit 143 mémorise le signal produit par le comparateur à chaque impulsion du signal CLK et le signal D4 de défaut mémorisé est disponible sur sa sortie.

Le signal CLK est produit par le circuit 160 d'horloge à des intervalles réguliers, par exemple toutes heures, une fois par jour ou par semaine. Le signal CLK est de préférence synchronisé sur la fréquence du réseau sous surveillance. De préférence encore, la 1^{ère} impulsion du signal CLK est produite à bref délai (quelques secondes) après l'installation de l'appareil de surveillance dans un socle de prise 110.

A noter que, dans l'exemple de la figure 1, seul l'organe de détection 140 comprend un circuit de mémorisation. Il est cependant possible d'ajouter un circuit de mémorisation aux autres organes 120, 130 de détection pour mémoriser les signaux de défaut qu'ils produisent.

Le circuit de calibrage 170 comprend un bouton de sélection 190 disposé sur le boîtier 100 et accessible depuis l'extérieur, une source de courant 194 et un convertisseur 196.

Le bouton de sélection 190 permet à un utilisateur de préciser la valeur du courant de coupure IDN associé au disjoncteur différentiel du réseau sous surveillance, pour adapter l'appareil de détection au réseau à surveiller.

En fonction du courant de coupure choisi, le circuit 170 de calibrage produit un courant de défaut calibré IDN (de préférence égal au courant de coupure). Le circuit 170 fournit également la tension TRMAX fonction du courant de défaut IDN et de la résistance de fuite à la terre maximale admissible.

La source de courant 194 produit le courant IDN de défaut calibré en fonction de l'indication du bouton de sélection 190. Le convertisseur 196 produit la tension TRMAX en fonction du courant de défaut IDN et de la résistance de fuite à la terre maximale admissible ; la tension TRMAX est fournie à l'organe 140 de détection de la résistance de terre.

Le courant de défaut IDN produit par le circuit de calibrage 170 est également appliqué entre la borne de phase et la borne de terre du socle 110 par l'intermédiaire d'un bouton poussoir 192. Le bouton poussoir 192 et le circuit de calibrage 170 forment ainsi un circuit de test du disjoncteur différentiel du réseau : lorsqu'un utilisateur appuie sur le bouton poussoir 192, un courant IDN est envoyé entre la borne de phase et la borne de terre du socle 110 et provoque le déclenchement du disjoncteur différentiel si ce dernier est dans un état de fonctionnement correct.

Dans l'exemple de la figure 1, le dispositif 200 de signalisation des défaut est un boîtier indépendant qui reçoit les signaux D1, D2, D3, D4 produits par les organes de détection 120, 130, 140 et qui affiche ces informations sous la forme de signaux lumineux et de signaux sonores.

Dans l'exemple figure 1, le dispositif de signalisation comprend 6 dispositifs lumineux de type diodes électroluminescentes (en abrégé DEL, encore connu sous le nom de Light Electroluminescent Diode ou LED en langage anglosaxon), et un dispositif sonore de type buzzer.

Le buzzer est ici prévu pour être activé chaque fois qu'un défaut est détecté et quel que soit le défaut. Il est ensuite réactivé à intervalles réguliers (par exemple toutes les 10 mn) si le défaut persiste.

Une 1^{ère} diode rouge s'allume lorsque la tension de terre est supérieure à la valeur maximale TTMAX admissible (signal D3 actif). Une 2^{ème} diode rouge s'allume lorsque la résistance de terre est supérieure à sa valeur maximale TRMAX admissible (signal D4 actif). Une 3^{ème} diode rouge s'allume lorsque la borne de terre du socle 110 est mal ou n'est pas connectée. Une 4^{ème} diode rouge s'allume lorsque la tension de phase est supérieure à TPMAX (signal D1 actif). Une 5^{ème} diode jaune s'allume lorsque la tension de phase est inférieure à sa valeur minimale admissible TPMIN (signal D2 actif). Enfin, une 6^{ème} diode verte s'allume pour indiquer qu'il n'y a pas de défaut de tension de phase.

Le choix de diodes de différentes couleurs permet de mettre en évidence les défauts les plus graves par rapport aux autres. Dans l'exemple, une diode rouge est utilisée pour indiquer que la tension de phase dépasse sa valeur maximale admissible, ce qui présente un réel danger pour les personnes et les équipements électriques, et une diode jaune est utilisée pour signaler que la tension de phase est inférieure à sa valeur minimale admissible, ce qui risque d'entraîner un disfonctionnement des équipements électriques mais qui est toutefois moins dangereux qu'une surtension.

Les diodes rouge ou jaune sont allumées tant que le signal de défaut correspondant est actif, elles sont éteintes sinon. Si le dit signal est mémorisé, par exemple dans le circuit de mémorisation 143, alors la diode associée reste allumée.

Dans l'exemple de la figure 1, les signaux D1, D2, D3, D4 produits par les organes de détection 120, 130, 140 sont transmis au dispositif de signalisation par voie hertzienne (par exemple à une fréquence de 433MHz), par des signaux modulés en amplitude. Le dispositif de signalisation comprend un accumulateur pour alimenter les diodes et le buzzer.

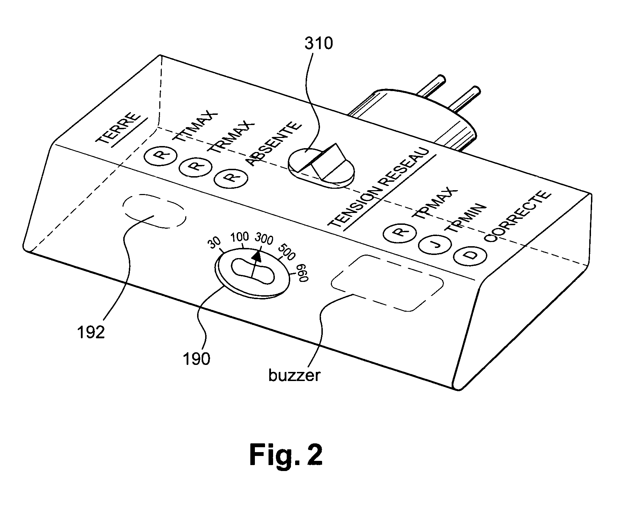

Dans l'exemple de la figure 2, le dispositif de détection 100 et le dispositif de signalisation des défauts sont regroupés dans un même boîtier enfichable dans un socle de prise 3 bornes.

L'appareil de la figure 2 comprend également un circuit d'inversion 310, de type interrupteur à deux entrées et une sortie. Le circuit d'inversion permet d'inverser les points de connexion de l'appareil de surveillance aux bornes de phase et de neutre du socle de prise sur lequel l'appareil est installé. Ainsi, quelles que soient les connexions de phase et de neutre dans le socle de prise, l'appareil peut être utilisé de sorte que la face du boîtier sur laquelle les diodes sont apparentes soit facilement visible; il suffit pour cela de positionner de manière adéquate le circuit d'inversion 310.

## Revendications

1. Appareil de surveillance permanente d'un réseau électrique, notamment un réseau domestique, enfichable sur un socle (110) de prise électrique comprenant une borne de phase, une borne de terre et une borne de neutre, l'appareil comprenant une pluralité d'organes de détection (120, 130, 140) pour détecter le dépassement de valeurs limites de paramètres électriques du réseau et un dispositif de signalisation (200) pour signaler un défaut lorsqu'une valeur prédéfinie d'un paramètre est dépassée,
l'appareil de surveillance étant **caractérisé en ce que** les paramètres électriques comprennent notamment une tension de phase, une tension de terre et une résistance de terre.

2. Appareil selon la revendication 1, comprenant un organe de détection (120) de la tension de phase, pour mesurer la tension de phase entre la borne de phase et la borne de neutre et produire :
- un 1^{er} signal de défaut (D1) si la tension de phase devient supérieure à une tension maximale de phase (TPMAX), ou
- un 2^{ème} signal de défaut (D2) si la tension de phase devient inférieure à une tension minimale de phase (TPMIN).

3. Appareil selon l'une des revendications 1 à 2, comprenant un organe de détection de la tension de terre (130), pour mesurer la tension de terre entre la borne de terre et la borne de neutre et produire un 3^{ème} signal de défaut (D3) si la tension de terre devient supérieure à une tension maximale de terre (TTMAX).

4. Appareil selon l'une des revendications 1 à 3, comprenant un organe de détection de la résistance de terre (140) pour mesurer la résistance de terre sur la borne de terre du socle de prise et produire un 4^{ème} signal de défaut (D4) si la résistance de terre devient supérieure à une résistance maximale de terre (TRMAX).

5. Appareil selon la revendication 4, dans lequel l'organe de détection de la résistance de terre (140) est activé :
- une première fois quelques secondes après l'enfichage de l'appareil de surveillance dans un socle de prise, et / ou
- à des intervalles réguliers, par exemple des périodes de quelques heures.

6. Appareil selon l'une des revendications 4 ou 5, dans lequel la résistance maximale de terre est fonction d'un calibre de l'appareil de surveillance, le dit calibre étant fonction d'un disjoncteur différentiel du réseau électrique et / ou étant fixé par un utilisateur.

7. Appareil selon l'une des revendications 1 à 6, comprenant également un circuit de test (194, 192), pour produire, entre la borne de phase et la borne de terre une impulsion de courant calibrée en fonction du calibre de l'appareil de surveillance, le dit calibre étant fonction d'un disjoncteur différentiel du réseau électrique et / ou étant fixé par un utilisateur.

8. Appareil selon l'une des revendications 1 à 7, dans lequel un ou plusieurs organes de détection (120, 130, 140) comprennent un moyen de mémorisation (143) pour mémoriser un signal de défaut (D1, D2, D3, D4) détecté.

9. Appareil selon l'une des revendications 1 à 8, dans lequel le dispositif de signalisation (200) comprend un moyen de signalisation pour indiquer un ou plusieurs défauts s'il reçoit un ou plusieurs signaux de défaut de la pluralité d'organes de détection (120, 130, 140).

10. Appareil selon la revendication 9, dans lequel le dispositif de signalisation comprend un moyen de signalisation visuel comprenant un ou plusieurs dispositifs de signalisation lumineuse, par exemple des diodes électroluminescentes, qui sont éteints ou allumés en fonction de l'état actif ou inactif du ou des signaux de défaut.

11. Appareil selon l'une des revendications 9 ou 10, dans lequel le dispositif de signalisation (200) comprend un moyen de signalisation sonore comprenant un ou plusieurs buzzers activés si un ou des signaux de défaut sont actifs.

12. Appareil selon la revendication 11, dans lequel le ou les buzzers sont activés :
- une seule fois lorsque un ou des signaux de défauts deviennent actifs, ou
- à des intervalles réguliers si un ou des signaux de défaut sont maintenus actifs.

13. Appareil selon l'une des revendications 1 à 12, dans lequel la pluralité d'organes de détection (120, 130, 140) et le dispositif de signalisation (200) sont intégrés dans un même boîtier de l'appareil de surveillance.

14. Appareil selon l'une des revendications 1 à 12, dans lequel la pluralité d'organes de détection (120, 130, 140) sont intégrés dans le boîtier (100) de l'appareil de surveillance et dans lequel le dispositif de signalisation (200) est déporté par rapport au boîtier de l'appareil de surveillance, la pluralité d'organes de détection (120, 130, 140) et le dispositif de signalisation (200) étant reliés par une liaison filaire dédiée, une liaison hertzienne, une liaison infra-rouge une liaison par courants porteurs ou une liaison galvanique.
